(19) **Europäisches Patentamt**

**European Patent Office**

**Office européen des brevets**

(11) **EP 1 416 691 B1**

(12) **EUROPEAN PATENT SPECIFICATION**

(45) Date of publication and mention
of the grant of the patent:
**22.03.2006 Bulletin 2006/12**

(51) Int Cl.:
*H04L 27/00* (2006.01)    *H03D 3/00* (2006.01)

(21) Application number: **02024392.9**

(22) Date of filing: **04.11.2002**

(54) **I/Q imbalance correction in a quadrature transceiver**

Korrektur von I/Q Ungleichheiten in einem Quadratur-Sender-Empfänger

Correction d'un déséquilibre I/Q dans un émetteur-récepteur en quadrature

(84) Designated Contracting States:
**DE FR GB**

(43) Date of publication of application:
**06.05.2004 Bulletin 2004/19**

(73) Proprietor: **Sony Deutschland GmbH**
**10785 Berlin (DE)**

(72) Inventors:
• **Wang, Zhaocheng,**
**Adv. Tech. Center Stutgart**
**70327 Stuttgart (DE)**
• **Uno, Masahiro,**
**Adv. Tech. Center Stuttgart**
**70327 Stuttgart (DE)**

(74) Representative: **Rupp, Christian et al**
**Mitscherlich & Partner**
**Patent- und Rechtsanwälte**
**Sonnenstrasse 33**
**80331 München (DE)**

(56) References cited:
**US-A- 5 705 949**

• **PIERRE J W ET AL: "CONSIDERATIONS IN THE AUTOCALIBRATION OF QUADRATURE RECEIVERS" PROCEEDINGS OF THE INTERNATIONAL CONFERENCE ON ACOUSTICS, SPEECH, AND SIGNAL PROCESSING (ICASSP). DETROIT, MAY 9 - 12, 1995. STATISTICAL SIGNAL AND ARRAY PROCESSING, NEW YORK, IEEE, US, vol. 3 CONF. 20, 9 May 1995 (1995-05-09), pages 1900-1903, XP000533080 ISBN: 0-7803-2432-3**

# EP 1 416 691 B1

## Description

### FIELD AND BACKGROUND OF THE INVENTION

The underlying invention generally relates to the field of coherent modulator architectures for the processing of modulated RF signals of digital communication systems, especially to a processing unit realizing an effective I/Q imbalance correction for high-level modulation schemes, e.g. 16-QAM or 64-QAM under the coexistence of a carrier frequency error.

Coherent modulators are applied in communication systems which are composed of both in-phase (I) and quadrature (Q) channels. In case the gain of the I channel is not equal to that of the Q channel or if the phase difference between the I channel and the Q channel is not equal to $\pi/2$, I/Q imbalance arises. When high-level modulation schemes (e.g. 16-QAM, 64-QAM or 256-QAM) are used, said I/Q imbalance introduces severe performance loss. For this reason, an adequate calibration procedure conducting an I/Q imbalance correction has to be applied to adapt the gain of the I channel to that of the Q channel, and, simultaneously, to adjust the phase difference between the I channel and the Q channel to $\pi/2$.

### BRIEF DESCRIPTION OF THE STATE OF THE ART

Conventional approaches for executing an I/Q imbalance correction and DC offset cancellation usually pertain to a digital processing unit, which is integrated within the I/Q modulator according to the state of the art.

Conventional I/Q impairment correction procedures according to the state of the art are introduced in the three articles "Considerations in the Autocalibration of Quadrature Receivers" (ICASSP'95, Vol. 3, pp. 1900 to 1903) by J.W. Pierre and D.R. Fuhrmann, "A Novel Adaptive Mismatch Cancellation System for Quadrature IF Radio Receivers" (IEEE Trans. Circuits and Systems II: Analog and Digital Signal Processing, Vol. 46, No. 6, June 1999) by L. Yu and W.M. Snelgrove, and "Maximum-Likelihood Technique to quadrature parameter estimation" (ICASSP'94, pp. 561 to 564) by J.W. Pierre and R.A. Green. Thereby, the first article provides the basic mathematical mode and a simple algorithm for DC offset cancellation and I/Q mismatch correction. The performance of this algorithm is confirmed by a simulation of the I/Q mismatch introduced by the gain and phase imbalance of quadrature mixers. The second article illustrates a complex Least Mean Square (LMS) algorithm and an adaptive noise canceller to separate the desired signal and the image noise introduced by the I/Q mismatch. Finally, the third article presents a Maxitnum-Likelihood (ML) solution for a gain imbalance estimation in a quadrature receiver, which can be used for array processing applications. Moreover, formula derivations and simulations are provided to check the performance. However, all these papers only describe conventional I/Q impairment correction procedures without considering the coexistence of carrier frequency errors.

Next, the US-patent 5,705,949 is directed to a time-domain based calibration method for compensating the imbalance of the amplitude and phase between the I and the Q channel, in which correctable I/Q imbalance errors occurring in a complex receiver can be detected and digitally compensated without the use of special calibration signals. Thereby, differential DC offset errors are compensated by averaging the incoming I and Q signals and subtracting expected values of differential DC offsets, e.g. computed from the long-term average of the I and Q signals, in order to create new I and Q signals. Differential gain imbalance errors are corrected by calculating a Root Mean Square (RMS) average of the new I and Q signals and using compensation coefficients which are determined from either the RMS average or by a Stochastic Gradient Algorithm.

Next, the European patent application EP 0 608 577 A1 pertains to a Gaussian Minimum Shift Keying (GMSK) modulator with an automatic calibration, wherein I and Q signals are generated in a baseband processing unit and sent to a phase modulator. Thereby, a time-domain based calibration method for compensating the imbalance of the amplitude and phase between the I and the Q channel is disclosed. By generating known test signals, the power of the transmitted signal can advantageously be used to detect DC offsets, quadrature errors and I/Q imbalances. All these sorts of errors are sequentially corrected by means of three separate control loops, and three separate control signals are generated. In this connection, the control loops share a common power detector, thus reducing the required chip area.

Furthermore, the US patent 5,872,538 pertains to a frequency-domain based correction method for calibrating the imbalance of the amplitude and phase between the I and the Q signal obtained by the I/Q demodulator of a quadrature receiver, which is directly performed by exploiting the symmetry properties of the Discrete Fourier Transform (DFT) of a real signal, taking the in-phase component as the real part and the quadrature component as the imaginary part.

The European patent application EP 0 984 288 A1 refers to a wideband I/Q splitting apparatus to be used in a spectrum analyzer and an appropriate time-domain based calibration method, which is used for calibrating the group difference between the I and the Q channel.

All these patents are focused on various I/Q calibration methods, but do not consider the effect of a carrier frequency error generated by an incoming signal or a local oscillator (LO) during a normal I/Q calibration procedure.

OBJECT OF THE UNDERLYING INVENTION

In view of the explanations mentioned above, it is the object of the underlying invention to propose an approach which allows for a reduction of I/Q imbalance under the coexistence of a carrier frequency error.

The aforementioned object is achieved by means of the features in the independent patent claims. Advantageous features are defined in the dependent patent claims.

SUMMARY OF THE INVENTION

In order to achieve the object defined above, the proposed approach according to the underlying invention is dedicated to a novel calibration procedure for an I/Q modulator, which supports a compensation of amplitude offsets and phase imbalances and furthermore considers the coexistence of a carrier frequency error in order to obtain a set of accurate and reliable calibration coefficients. In this connection, a specially designed processing unit is integrated within the I/Q modulator. The invention can advantageously be applied when high-level modulation schemes, e.g. 16-QAM or 64-QAM, are used.

BRIEF DESCRIPTION OF THE DRAWINGS

Further advantages of the underlying invention result from the subordinate claims which are depicted in the following drawings. Herein,

Fig. 1    presents a block diagram showing a practical I/Q modulator applied to a quadrature transmitter and an ideal I/Q demodulator applied to a quadrature receiver,

Fig. 2    depicts a block diagram of an analog circuitry applied to the I/Q modulator of a quadrature transmitter executing an online I/Q imbalance compensation procedure, and

Fig. 3    presents a block diagram showing an I/Q modulator applied to a quadrature transmitter and an I/Q demodulator applied to a quadrature receiver, which illustrates a calibration procedure executing an I/Q imbalance compensation considering the existence of a carrier frequency error according to the underlying invention.

DETAILED DESCRIPTION OF THE UNDERLYING INVENTION

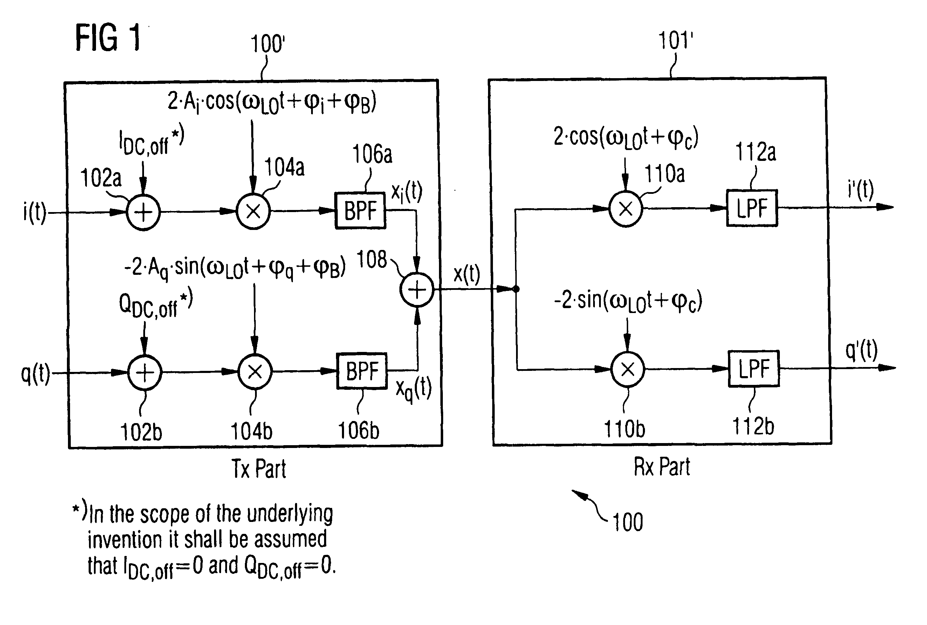

In the following, Figs. 1 to 3 shall be explained in detail. The meaning of the symbols designated with reference signs in Figs. 1 to 3 can be taken from an annexed table.

In Fig. 1, the test signals for the I and the Q channel are given by the two waveforms

$$i(t) = cos\,(\omega_0 \cdot t) \ \ \text{and} \ \ q\,(t) = sin\,(\omega_0 \cdot t) \ \text{with} \ \omega_0 = 2\pi \cdot f_0 \,,$$

wherein $f_0$ is the frequency of the test signals.

When the background noise is small, the obtained transmitter output for the I channel at the output port of the band-pass filter is given by the following equation:

$$x_i(t) = A_i \cdot cos\,\big[(\omega_{LO} - \omega_0) \cdot t + \varphi_i + \varphi_B\big] + A_i \cdot cos\,\big[(\omega_{LO} + \omega_0) \cdot t + \varphi_i + \varphi_B\big]. \quad (1a)$$

The transmitter output for Q channel after band-pass filter is given by

$$x_q(t) = A_q \cdot cos\,\big[(\omega_{LO} + \omega_0) \cdot t + \varphi_q + \varphi_B\big] - A_q \cdot cos\,\big[(\omega_{LO} - \omega_0) \cdot t + \varphi_q + \varphi_B\big]. \quad (1b)$$

Thereby,

$A_i$       denotes the amplitude of a signal generated by a local oscillator (LO) for the I channel,

$A_q$       denotes the amplitude of a signal generated by a local oscillator (LO) for the Q channel,

$\varphi_i$ and $\varphi_q$       are used to model the phase discrepancies between the I and the Q channel,

$\omega_{LO}$       denotes a circular frequency generated by a local oscillator (LO), and

$\varphi_B$       is the phase of the carrier relative to the test waveform in the transmitter (TX) part.

Hence, the output signal of the I channel of the RX part yields

$$i'(t) = \left[\left(x_i(t) + x_q(t)\right) \cdot 2 \cos\left(\omega_{LO} \cdot t + \varphi_C\right)\right]_{\omega < 2\pi \cdot f_{co}}$$

$$= A_i \cdot \cos\left(\omega_0 t - \varphi_i - \varphi_B + \varphi_C\right) + A_i \cdot \cos\left(\omega_0 t + \varphi_i + \varphi_B - \varphi_C\right)$$

$$+ A_q \cdot \cos\left(\omega_0 t + \varphi_q + \varphi_B - \varphi_C\right) - A_q \cdot \cos\left(\omega_0 t - \varphi_q - \varphi_B + \varphi_C\right), \quad (2a)$$

and the output signal of the Q channel of the RX part yields

$$q'(t) = -\left[\left(x_i(t) + x_q(t)\right) \cdot 2 \sin\left(\omega_{LO} \cdot t + \varphi_C\right)\right]_{\omega < 2\pi \cdot f_{co}}$$

$$= - A_i \cdot \sin\left(\omega_0 t - \varphi_i - \varphi_B + \varphi_C\right) + A_i \cdot \sin\left(\omega_0 t + \varphi_i + \varphi_B - \varphi_C\right)$$

$$+ A_q \cdot \sin\left(\omega_0 t + \varphi_q + \varphi_B - \varphi_C\right) + A_q \cdot \sin\left(\omega_0 t - \varphi_q - \varphi_B + \varphi_C\right). \quad (2b)$$

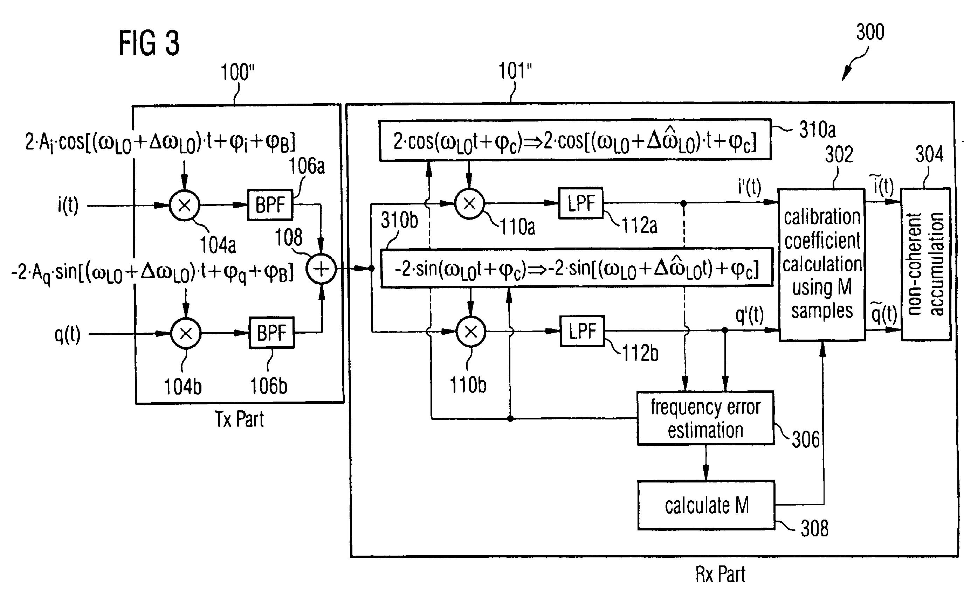

In this connection, $\varphi_C$ is the phase of the carrier relative to the test waveform in the receiver (RX) part, $f_{co}$ denotes the cut-off frequency of the low-pass filters 112a+b applied to the I/Q demodulator 101' (101") depicted in Figs. 1 and 3, respectively.

The conventional I/Q imbalance correction method according to the state of the art can be summarized as follows. Firstly, the estimation values are calculated by means of the following equations:

$$\Xi_r = \int_0^T i'(t) \cdot \cos \omega_0 t \, dt = T \cdot A_i \cdot \cos\left(\varphi_i + \varphi_B - \varphi_C\right), \quad (3a)$$

$$\Xi_q = -\int_0^T i'(t) \cdot \sin \omega_0 t \, dt = T \cdot A_q \cdot \sin\left(\varphi_q + \varphi_B - \varphi_C\right), \quad (3b)$$

$$H_r = \int_0^T q'(t) \cdot \sin \omega_0 t \, dt = T \cdot A_q \cdot \cos\left(\varphi_q + \varphi_B - \varphi_C\right), \quad (3c)$$

$$H_q = \int_0^T q'(t) \cdot \cos \omega_0 t \, dt = T \cdot A_i \cdot \sin\left(\varphi_i + \varphi_B - \varphi_C\right), \quad (3d)$$

wherein $T = N \cdot \dfrac{2\pi}{\omega_0}$ denotes the integration duration and *N* is an integer value larger than 1. After that, the complex-valued online calibration parameters *h* can be calculated as follows:

$$h = A \cdot cos(\theta) + j \cdot A \cdot sin(\theta) = \frac{\Xi_r + j \cdot H_q}{H_r + j \cdot \Xi_q} \qquad (4)$$

with $A = \dfrac{A_i}{A_q}$ and $\theta = \varphi_i - \varphi_q$,

wherein

$A$      denotes the amplitude imbalance ratio between the I and the Q signal and
$\theta$      is the phase discrepancy between the I and the Q signal.

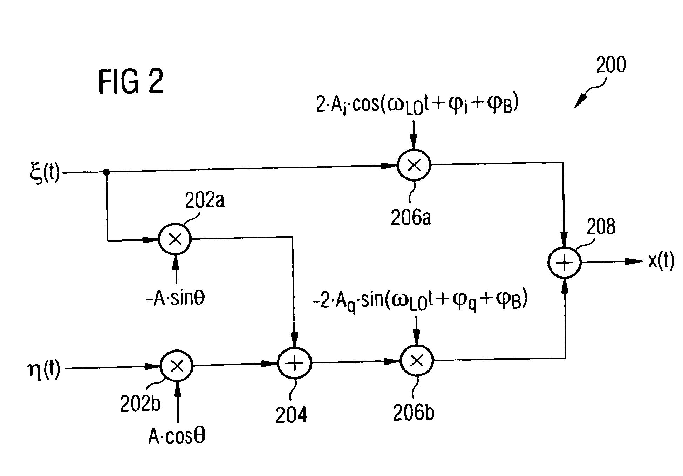

A block diagram of a circuitry applied to the I/Q modulator, which illustrates said online I/Q imbalance compensation procedure, is shown in Fig. 2.

After the pre-distortion of the input signal, the practical RF signal to be transmitted is given by the following equation, wherein $\xi(t)$ and $\eta(t)$ are the practical I and Q channel input signals instead of the previously applied test waveforms $i(t)$ and $q(t)$ introduced in Fig. 1:

$$
\begin{aligned}
x(t) &= \xi(t) \cdot 2\,A_i \cdot cos\left(\omega_{LO} \cdot t + \varphi_q + \varphi_B + \theta\right) \qquad (5)\\
&\quad + \xi(t) \cdot A \cdot sin(\theta) \cdot 2\,A_q \cdot sin\left(\omega_{LO} \cdot t + \varphi_q + \varphi_B\right)\\
&\quad - \eta(t) \cdot A \cdot cos(\theta) \cdot 2\,A_q \cdot sin\left(\omega_{LO} \cdot t + \varphi_q + \varphi_B\right)\\
&= \xi(t) \cdot 2\,A_i \cdot cos\left(\omega_{LO} \cdot t + \varphi_q + \varphi_B + \theta\right)\\
&\quad + \xi(t) \cdot sin(\theta) \cdot 2\,A_i \cdot sin\left(\omega_{LO} \cdot t + \varphi_q + \varphi_B\right)\\
&\quad - \eta(t) \cdot cos(\theta) \cdot 2\,A_i \cdot sin\left(\omega_{LO} \cdot t + \varphi_q + \varphi_B\right)\\
&= \xi(t) \cdot 2\,A_i \cdot cos\left(\omega_{LO} \cdot t + \varphi_q + \varphi_B\right) \cdot cos(\theta)\\
&\quad - \xi(t) \cdot 2\,A_i \cdot sin\left(\omega_{LO} \cdot t + \varphi_q + \varphi_B\right) \cdot sin(\theta)\\
&\quad + \xi(t) \cdot sin(\theta) \cdot 2\,A_i \cdot sin\left(\omega_{LO} \cdot t + \varphi_q + \varphi_B\right)\\
&\quad - \eta(t) \cdot cos(\theta) \cdot 2\,A_i \cdot sin\left(\omega_{LO} \cdot t + \varphi_q + \varphi_B\right)\\
&= \left[\xi(t) \cdot 2\,A_i \cdot cos\left(\omega_{LO} \cdot t + \varphi_q + \varphi_B\right) - \eta(t) \cdot 2\,A_i \cdot sin\left(\omega_{LO} \cdot t + \varphi_q + \varphi_B\right)\right] \cdot cos(\theta).
\end{aligned}
$$

From equation (5) it becomes evident that the gain of the I channel is the same of that of the Q channel, the carrier phase difference between I and Q channel is $\pi/2$, and thus the I/Q imbalance correction is implemented successfully.

The above-described calibration procedure according to the state of the art does not consider the effect of noise and carrier frequency error. For example, in a HiperLAN system 20 ppm carrier frequency error is imagined, which means that for an intermediate carrier frequency (IF) of 280 MHz, the carrier frequency error $\Delta f_{RF}$ to be expected yields 5.6 kHz. For the receiver (RX) part, the analog signal has to be sampled for post-processing. On the assumption that the sampling frequency $f_s$ is 20 MHz and an I/Q imbalance error $\theta$ of 2° shall be corrected by applying equations (3a) to (3d), the following equation has to be satisfied:

$$\frac{\Delta\omega_{RF}\cdot M}{\omega_s} = \frac{\Delta f_{RF}\cdot M}{f_s} \leq \frac{\theta}{360°}, \qquad (6)$$

wither $\omega_{RF} = 2\pi \cdot f_{RF}$ and $\Delta\omega_{RF} = 2\pi \cdot \Delta f_{RF}$,

wherein $M$ is the number of samples for the integration period $T$, which can be calculated after a transformation of equation (6):

$$M \leq M_{max} = \left\lfloor \frac{\theta}{360°}\cdot\frac{f_s}{\Delta f_{RF}} \right\rfloor = 19 \text{ for } \theta = 2° \text{ and } \Delta f_{RF} = 5.6 \text{ kHz}. \qquad (7)$$

Since the integration period should be an integer multiple of the fundamental period $\dfrac{2\pi}{\omega_o}$, $M$ should be an integer multiple of 4. Thus, the maximum value of $M = 16$ sam-ples has to be chosen for the integration period $T$ to get the estimation values $\Xi_r, \Xi_q, H_r, and H_q$ based on equations (3a) to (3d). Thereafter, equation (4) has to be circumscribed as follows in order to get the calibration coefficients:

$$h(M) = \frac{\Xi_r(M) + j\cdot H_q(M)}{H_r(M) + j\cdot\Xi_q(M)}. \qquad (8)$$

Due to the effect of noise, the integer value of $M$ should not be too small. Otherwise, a reliable coefficient estimation is not achievable. At the same time, as emphasized, $M$ is limited to integer values smaller than the upper threshold value $M_{max}$ calculated by equation (6) due to the existence of the carrier frequency error $\Delta f_{RF}$.

According to one embodiment of the underlying invention, this dilemma can be solved by applying a so-called non-coherent accumulation of the calculated calibration coefficients based on equation (6) and a small number of samples. The detailed information is summarized as follows:

Steps #1:   For $k = 1$ to $K$: Using the $[(k-1)\cdot M]$-th to the $(k\cdot M$-1)-th sample from a set of $M \cdot K$ samples to calculate the calibration coefficients $h_k (M)$.

Step #2:   Calculate the calibration coefficient as the arithmetic mean of said calibration coefficients $h_k(M)$ according to the following formula:

$$h(M) = \frac{1}{K}\cdot\sum_{k=1}^{K} h_k(M). \qquad (9)$$

Therefore, noise reduction can be achieved by using a large number of $M \cdot K$ samples, and the effect of carrier frequency error $\Delta f_{RF}$ can be reduced by using a small number of $M$ samples. In conclusion, reliable calibration coefficients can be obtained by considering the coexistence of noise and carrier frequency error.

In addition, a novel calibration structure according to one embodiment of the underlying invention as depicted in Fig. 3 is proposed, wherein a simple frequency error estimation block 306 is included. Conventional adaptive frequency error correction includes two parts: an acquisition module which limits the frequency error to a predefined range and a more complex tracking module which further reduces the frequency error in order to satisfy the system requirement. Here only a simple frequency acquisition module is recommended to use, that provides only a rough estimation of the carrier frequency error $\Delta f_{RF}$. However, it fulfills the following two functions:

1. It decides the value of M for a non-coherent accumulation of the calibration coefficients $h_k(M)$, and

2. it reduces the carrier frequency error partly in order to facilitate the conventional calibration procedure (I/Q imbalance correction), by adjusting a local oscillator (LO) as shown in Fig. 3.

Thereby, the units 310a+b and the shadowed parts 304, 306, and 308 are added to the conventional calibration procedure.

For this purpose, the calibration function explained above is modified by replacing the circular frequency $\omega_{LO}$ generated by a local oscillator by the term $\omega_{LO} + \Delta\hat{\omega}_{LO}$, wherein $\Delta\hat{\omega}_{LO}$ denotes an estimated frequency offset value. This frequency offset $\Delta\hat{\omega}_{LO}$ is stored in a memory when the circuit is turned off and used as the initial value of the frequency offset value when the circuit is turned on. In this case, the value of $M$ can gradually be increased from the beginning of the calibration iteration (step #1), and the number of iterations ($K$) can be reduced.

According to the underlying invention, the following carrier update functions are applied:

$$2\cos(\omega_{LO}\cdot t + \varphi_C) \text{ is replaced by } 2\cos\left[(\omega_{LO} + \Delta\hat{\omega}_{LO})\cdot t + \varphi_C\right] \quad (10a)$$

$$-2\sin(\omega_{LO}\cdot t + \varphi_C) \text{ is replaced by } -2\sin\left[(\omega_{LO} + \Delta\hat{\omega}_{LO})\cdot t + \varphi_C\right] \quad (10b)$$

$$\text{for } \Delta\hat{\omega}_{LO} \geq \Delta\hat{\omega}_{LO.\ min},$$

wherein $\Delta\hat{\omega}_{LO.\ min}$ denotes a predefined threshold value in order to avoid the fluctuation of the frequency adjustment caused by background noise, etc.

Table: Depicted Features and their Associated Reference Signs

| No. | Technical Features and System Components |
|---|---|
| 100 | block diagram showing a practical I/Q modulator 100' applied to a quadrature transmitter and an ideal I/Q demodulator 101' applied to a quadrature receiver |
| 100' | I/Q modulator of a first mobile transceiver depicted in Fig. 1, realized as a quadrature transmitter |
| 100" | I/Q modulator of a first mobile transceiver according to an embodiment of the underlying invention depicted in Fig. 3, realized as a quadrature transmitter |
| 101' | I/Q demodulator of a second mobile transceiver depicted in Fig. 1, realized as a quadrature receiver |
| 101" | I/Q demodulator of a second mobile transceiver according to an embodiment of the underlying invention depicted in Fig. 3, realized as a quadrature receiver |
| 102a | summation element in the I chain of the I/Q modulator 100', which is used for modeling the DC offset of the I signal |
| 102b | summation element in the Q chain of the I/Q modulator 100', which is used for modeling the DC offset of the Q signal |
| 104a | up-conversion mixer in the I chain of the I/Q modulator 100'/100", which realizes a direct up-conversion of the I signal from the baseband to the passband by multiplying said I signal with a CW signal originating from a local oscillator (LO) |
| 104b | up-conversion mixer in the Q chain of the I/Q modulator 100'/100", which realizes a direct up-conversion of the Q signal from the baseband to the passband by multiplying said Q signal with a CW signal originating from a local oscillator (LO) |

Table continued

| No. | Technical Features and System Components |
| --- | --- |
| 106a | band-pass filter (BPF) in the I chain of the I/Q modulator 100'/100'' |
| 106b | band-pass filter (BPF) in the Q chain of the I/Q modulator 100'/100" |
| 108 | summation element at the output port of the I/Q modulator 100'/100'' |
| 110a | down-conversion mixer in the I chain of the I/Q demodulator 101'/101'', which |
| | realizes a direct down-conversion of the received RF signal from the passband to the baseband by multiplying said RF signal with a CW signal originating from a local oscillator (LO) |
| 110b | down-conversion mixer in the Q chain of the I/Q demodulator 101'/101", which realizes a direct down-conversion of the received RF signal from the passband to the baseband by multiplying said RF signal with a CW signal originating from a local oscillator (LO) |
| 112a | low-pass filter (LPF) in the I chain of the I/Q demodulator 101'/101" |
| 112b | low-pass filter (LPF) in the Q chain of the I/Q demodulator 101'/ 101 " |
| 200 | block diagram of an analog circuitry applied to the I/Q modulator 100'/100" of a quadrature transmitter executing an online I/Q imbalance compensation procedure |
| 202a | first multiplier of the analog circuitry 200 |
| 202b | second multiplier of the analog circuitry 200 |
| 204 | first summation element of the analog circuitry 200 |
| 206a | up-conversion mixer in the I chain of the analog circuitry 200, which realizes a direct up-conversion of the I signal from the baseband to the passband by multiplying said I signal with a CW signal originating from a local oscillator (LO) |
| 206b | up-conversion mixer in the Q chain of the analog circuitry 200, which realizes a direct up-conversion of the Q signal from the baseband to the passband by multiplying said Q signal with a CW signal originating from a local oscillator (LO) |
| 208 | second summation element of the analog circuitry 200 |
| 300 | block diagram showing an I/Q modulator 100'/100'' applied to a quadrature transmitter and an I/Q demodulator 101'/101" applied to a quadrature receiver, which illustrates a calibration procedure executing an I/Q imbalance compensation considering the existence of a carrier frequency error according to the underlying invention |
| 302 | calibration unit for iteratively calculating calibration coefficients $h_k(M)$ needed for conducting an I/Q imbalance correction and DC offset cancellation procedure |
| | according to one embodiment of the underlying invention, based on M samples per integration period $T$ |
| 304 | unit for a non-coherent accumulation of the iteratively calculated calibration coefficients $h_k(M)$ |
| 306 | unit for an estimation of the carrier frequency error $\Delta f_{RF}$ |
| 308 | unit for the calculation of the maximum number of samples ($M_{max}$) per integration period $T$ according to equation (15) |

Table continued

| No. | Technical Features and System Components |
|---|---|
| 310a | unit providing the carrier update function 2 cos $[(\omega_{LO} + \Delta\hat{\omega}_{LO}) \cdot t + \varphi_c]$ fed to the down-conversion mixer 102a in the I chain of the I/Q demodulator applied to the quadrature receiver |
| 310b | unit providing the carrier update function - 2 *sin* $[(\omega_{LO} + \Delta\hat{\omega}_{LO}) \cdot t + \varphi_c]$ fed to the down-conversion mixer 102b in the Q chain of the I/Q demodulator applied to the quadrature receiver |

**Claims**

1. A method for calibrating the in-phase and quadrature signals sent from a modulator to a demodulator, wherein:

    - two test signals of frequency $f_0 = \omega_0/2\pi$ are fed to the in-phase and quadrature channels of the modulator,

    - a calibration coefficient $h = \dfrac{\Xi_r + j \cdot H_q}{H_r + j \cdot \Xi_q}$ is calculated,

    with $\Xi_r = \int_0^T i'(t) \cdot \cos \omega_0 t\, dt$, $\Xi_q = - \int_0^T i'(t) \cdot \sin \omega_0 t\, dt$,

    $H_r = \int_0^T q'(t) \cdot \sin \omega_0 t\, dt$, $H_q = \int_0^T q'(t) \cdot \cos \omega_0 t\, dt$,

    wherein T is a multiple of the period $T_0 = 2\pi/\omega_0$, and i'(t) and q'(t) are the down-converted in-phase and quadrature signals of the demodulator,

    **characterized by** the steps of

    - estimating the carrier frequency error $\Delta f_{RF}$,
    - sampling at a frequency $f_s$ the signals i'(t) and q'(t),
    - calculating a number M of samples for the integration period T on the basis of following inequality:

    $$M \leq M_{max} = \frac{\theta}{360°} \cdot \frac{f_s}{\Delta f_{RF}}$$ , M being an integer multiple of 4 and $\theta$ being the I/Q phase imbalance error to be corrected,
    - averaging K different calibration coefficients $h_1$ to $h_K$,
    - adjusting a local oscillator of the demodulator, whereby the influences of a carrier frequency error are reduced.

2. A method according to claim 1,
   **characterized in that**
   the value of M is set larger as the estimated carrier frequency error $\Delta f_{RF}$ decreases.

3. A method according to any of the preceding claims,
   **characterized in that**
   the number of repetitions K is set larger as the value of the number of signal samples M decreases.

4. A method according to any of the preceding claims,
   **characterized in that**
   the test signals cos $(\omega_0 t)$ and sin $(\omega_0 t)$ are fed to the in-phase and quadrature channels of the modulator respectively.

5. A method according to any of the preceding claims,
   wherein
   the 16-QAM or 64-QAM scheme is used.

6. A method according to any of the preceding claims, comprising the steps of

    - storing the estimated frequency offset value, by which the local oscillator is adjusted, when said demodulator is switched off, and
- using the stored frequency offset value when said demodulator is switched on.

**7.** An I/Q demodulator,

comprising a processing unit (302) for calculating a calibration coefficient $h = \dfrac{\Xi_r + j \cdot H_q}{H_r + j \cdot \Xi_q}$ ,

with $\Xi_r = \int_0^T i'(t) \cdot \cos \omega_0 t \, dt$ , $\Xi_q = -\int_0^T i'(t) \cdot \sin \omega_0 t \, dt$ ,

$H_r = \int_0^T q'(t) \cdot \sin \omega_0 t \, dt$ , $H_q = \int_0^T q'(t) \cdot \cos \omega_0 t \, dt$ ,

wherein T is a multiple of the period $T_0 = 2\pi/\omega_0$, $f_0 = \omega_0/2\pi$ being the frequency of two test signals fed to the in-phase and quadrature channels of a modulator, and i' (t) and q' (t) are the down-converted in-phase and quadrature signals of the demodulator,
**characterized in that** it comprises

- a carrier frequency estimation unit (306) for estimating the carrier frequency error $\Delta f_{RF}$,
- a unit (308) for calculating a number M of samples of the signals i'(t) and q'(t) for the integration period T on the basis of following inequality: $M \le M_{max} = \dfrac{\theta}{360°} \cdot \dfrac{f_s}{\Delta f_{RF}}$ , M being an integer multiple of 4, $\theta$

being the I/Q phase imbalance error to be corrected, and $f_s$ the sampling frequency,
- a unit (304) for averaging K different calibration coefficients $h_1$ to $h_K$.

**8.** An I/Q demodulator according to claim 7,
**characterized by**
means for setting the value of M larger as the estimated carrier frequency error $\Delta f_{RF}$ decreases.

**9.** An I/Q demodulator according to any of claim 7 or 8,
**characterized by**
means for setting the number of repetitions K larger as the value of the number of signal samples M decreases.

**10.** An I/Q demodulator according to any of claims 7 to 9,
wherein
the 16-QAM or 64-QAM scheme is used.

**11.** An I/Q demodulator according to any of claims 7 to 10, comprising

- a memory for storing the estimated frequency offset value, by which the local oscillator is adjusted, when said I/Q demodulator is switched off, and
- means for using the frequency offset value stored in the memory when said I/Q demodulator is switched on.


**Patentansprüche**

**1.** Verfahren zum Kalibrieren der Inphase- und Quadratursignale, die von einem Modulator zu einem Demodulator gesendet werden, wobei

- zwei Testsignale mit der Frequenz $f_0 = \omega_0/2\pi$ dem Inphase- und dem Quadraturkanal des Modulators zugeführt werden,
- ein Kalibrierungskoeffizient $h = \dfrac{\Xi_r + j \cdot H_q}{H_r + j \cdot \Xi_q}$ berechnet wird,

mit $\Xi_r = \int_0^T i'(t) \cdot \cos \omega_0 t \, dt$ , $\Xi_q = -\int_0^T i'(t) \cdot \sin \omega_0 t \, dt$ ,

$H_r = \int_0^T q'(t) \cdot \sin \omega_0 t \, dt$ , $H_q = \int_0^T q'(t) \cdot \cos \omega_0 t \, dt$

worin T ein Vielfaches der Periode $T_0 = 2\pi/\omega_0$ ist und i'(t) und q'(t) die abwärtsgewandelten Inphase- und Quadratursignale des Demodulators sind,

**gekennzeichnet durch** die Verfahrensschritte:

- Schätzen des Trägerfrequenzfehlers $\Delta f_{RF}$,
- Abtasten der Signale i'(t) und q'(t) mit einer Frequenz $f_s$,
- Berechnen einer Anzahl M von Abtastproben für die Integrationsperiode T auf der Basis der folgenden Ungleichung:

$$M \leq M_{max} = \frac{\theta}{360°} \cdot \frac{f_s}{\Delta f_{RF}},$$

worin M ein ganzzahliges Vielfaches von 4 und θ der zu korrigierende I/Q-Phasenungleichgewichtsfehler ist,
- Mittelwertbildung von K verschiedenen Kalibrierungskoeffizienten $h_1$ bis $h_K$,
- Justieren eines lokalen Oszillators des Demodulators,
wodurch die Einflüsse eines Trägerfrequenzfehlers reduziert werden.

2. Verfahren nach Anspruch 1,
   **dadurch gekennzeichnet,**
   **daß** der Wert von N größer gesetzt wird, wenn der geschätzte Trägerfrequenzfehler $\Delta f_{RF}$ kleiner wird.

3. Verfahren nach einem der vorhergehenden Ansprüche,
   **dadurch gekennzeichnet,**
   **daß** die Wiederholungszahl K größer gesetzt wird, wenn der Wert der Zahl M der Signalabtastproben kleiner wird.

4. Verfahren nach einem der vorhergehenden Ansprüche,
   **dadurch gekennzeichnet,**
   **daß** die Testsignale $\cos(\omega_0 t)$ und $\sin(\omega_0 t)$ dem Inphase- bzw. dem Quadraturkanal des Demodulators zugeführt werden.

5. Verfahren nach einem der vorhergehenden Ansprüche,
   bei dem das 16-QAM- oder das 64-QAM-Schema benutzt wird.

6. Verfahren nach einem der vorhergehenden Ansprüche, mit den Verfahrensschritten:

   - Speichern des geschätzten Frequenzoffsetwerts, durch den der lokale Oszillator justiert wird, wenn der Demodulator ausgeschaltet wird, und
   - Verwenden des gespeicherten Frequenzoffsetwerts, wenn der Demodulator eingeschaltet wird.

7. I/Q-Demodulator

   mit einer Verarbeitungseinheit (302) zum Berechnen eines Kalibrierungskoeffizienten $h = \dfrac{\Xi_r + j \cdot H_q}{H_r + j \cdot \Xi_q}$,

   mit $\Xi_r = \int_0^T i'(t) \cdot \cos\omega_0 t \, dt$, $\Xi_q = -\int_0^T i'(t) \cdot \sin\omega_0 t \, dt$,
   $H_r = \int_0^T q'(t) \cdot \sin\omega_0 t \, dt$ , $H_q = \int_0^T q'(t) \cdot \cos\omega_0 t \, dt$
   worin T ein Vielfaches der Periode $T_0 = 2\pi/\omega_0$ ist, $f_0 = \omega_0/2\pi$ die Frequenz zweier Testsignale ist, die dem Inphase- und dem Quadraturkanälen des Modulators zugeführt werden, und i'(t) und q'(t) die abwärtsgewandelten Inphase- und Quadratursignale des Demodulators sind,
   **gekennzeichnet durch**

   - eine Trägerfrequenzschätzeinheit (306) zum Schätzen des Trägerfrequenzfehlers $\Delta f_{RF}$,
   - eine Einheit (308) zum Berechnen einer Anzahl von Abtastproben für die Integrationsperiode T auf der Basis der folgenden Ungleichung:

$$M \leq M_{max} = \frac{\theta}{360°} \cdot \frac{f_s}{\Delta f_{RF}},$$

   worin M ein ganzzahliges Vielfaches von 4 und θ der zu korrigierende I/Q-Phasenungleichgewichtsfehler ist und $f_s$ die Abtastfrequenz ist, und

- eine Einheit (304) zur Mittelwertbildung von K verschiedenen Kalibrierungskoeffizienten $h_1$ bis $h_K$,

8. I/Q-Demodulator nach Anspruch 7,
   **gekennzeichnet durch**
   Mittel, um den Wert von N größer zu setzen, wenn der geschätzte Trägerfrequenzfehler $\Delta f_{RF}$ kleiner wird.

9. I/Q-Demodulator nach einem der Ansprüche 7 oder 8,
   **gekennzeichnet durch**
   Mittel, um die Wiederholungszahl K größer zu setzen, wenn der Wert Zahl M der Signalabtastproben kleiner wird.

10. I/Q-Demodulator nach einem der Ansprüche 7 bis 9,
    bei dem das 16-QAM- oder das 64-QAM-Schema benutzt wird.

11. I/Q-Demodulator nach einem der Ansprüche 7 bis 10 mit

    - einem Speicher zum Speichern des geschätzten Frequenzoffsetwerts, durch den der lokale Oszillator justiert wird, wenn der I/Q-Demodulator ausgeschaltet wird, und
    - Mittel zum Verwenden des gespeicherten Frequenzoffsetwerts, wenn der I/Q-Demodulator eingeschaltet wird.

**Revendications**

1. Procédé d'étalonnage des signaux en phase et en quadrature envoyés d'un modulateur à un démodulateur, selon lequel :

   - deux signaux de test ayant la fréquence $f_0=\omega_0/2\pi$ sont envoyés aux canaux en phase et en quadrature du modulateur,
   - un coefficient d'étalonnage $h = \dfrac{\Xi_r + j \cdot H_q}{H_r + j \cdot \Xi_q}$ est calculé,

   avec $\Xi_r = \int_0^T i'(t) \cdot \cos \omega_0 t \, dt$ V,V $\Xi_q = - \int_0^T q'(t) \cdot \sin \omega_0 t \, dt$,

   $H_r = \int_0^T q'(t) \cdot \sin w_0 t \, dt$, $H_q = \int_0^T q'(t) \cdot \cos \omega_0 t \, dt$,

   T étant un multiple de la période $T_0=2\pi/\omega_0$ et i' (t) et q'(t) étant les signaux en phase et en quadrature convertis dans le sens décroissant, du démodulateur,

   **caractérisé par** les étapes consistant à :

   - estimer l'erreur de fréquence porteuse $\Delta f_{RF}$,
   - échantillonner à une fréquence $f_s$ les signaux i' (t) et q'(t),
   - calculer un nombre M d'échantillons pour la période d'intégration T sur la base de l'inégalité suivante :

   $M \leq M_{max} = \dfrac{\theta}{360°} \cdot \dfrac{f_s}{\Delta f_{RF}}$, M étant un multiple entier de 4 et $\theta$ étant l'erreur de déséquilibre de phase I/Q devant être corrigée,

   - former la moyenne de K coefficients d'étalonnage différents $h_1$ à $h_k$,
   - ajuster un oscillateur local du démodulateur, ce qui a pour effet que les influences d'une erreur de fréquence porteuse sont réduites.

2. Procédé selon la revendication 1, **caractérisé en ce que**
   la valeur de M est réglée à une valeur plus élevée lorsque l'erreur de fréquence de porteuse estimée $\Delta f_{RF}$ diminue.

**3.** Procédé selon l'une quelconque des revendications précédentes, **caractérisé en ce** le nombre de répétitions K est réglé à une valeur plus élevée lorsque la valeur du nombre d'échantillons de signaux M diminue.

**4.** Procédé selon l'une quelconque des revendications précédentes, **caractérisé en ce** les signaux de test $\cos(\omega_0 t)$ et $\sin(\omega_0 t)$ sont envoyés respectivement aux canaux en phase et en quadrature du modulateur.

**5.** Procédé selon l'une quelconque des revendications précédentes, dans lequel on utilise le système 16-QAM ou 64-QAM.

**6.** Procédé selon l'une quelconque des revendications précédentes, comprenant les étapes consistant à :

- mémoriser la valeur de décalage de fréquence estimée, avec laquelle l'oscillateur local est ajusté lorsque ledit démodulateur est débranché, et
- utiliser la valeur de décalage de fréquence mémorisée lorsque ledit démodulateur est branché.

**7.** Démodulateur I/Q comprenant une unité de traitement (303) pour calculer un

- coefficient d'étalonnage $h = \dfrac{\Xi_r + j.H_q}{H_r + j.\Xi_q}$,

avec $\Xi_r = \displaystyle\int_0^T i'(t).\cos(\omega_0 t\, dtV, V \quad \Xi_q \approx -\int_0^T q'(t).\sin\omega_0 t\, dt,$

$H_r = \displaystyle\int_0^T q'(t).\sin\omega_0 t\, dt, H_q \quad H_q = \int_0^T q'(t).\cos\omega_0 t\, dt,$

T étant un multiple de la période $T_0 = 2\pi/\omega_0$, $f_0 = \omega_0/2\pi$ étant la fréquence de deux signaux de test envoyés aux canaux en phase et en quadrature d'un modulateur, et i'(t) et q'(t) sont les signaux en phase et en quadrature, convertis dans le sens décroissant, du démodulateur,

**caractérisé en ce qu'**il comprend :

une unité (306) d'estimation de la fréquence porteuse pour estimer l'erreur de fréquence porteuse $\Delta f_{RF}$,
- une unité (308) pour calculer un nombre M d'échantillons des signaux i'(t) et q'(t) pour la période d'intégration T sur la base de l'inégalité suivante :

$$M \leq M_{max} = \frac{\theta}{360°} \cdot \frac{f_s}{\Delta f_{RF}},$$ M étant un multiple entier de 4, $\theta$ étant l'erreur de déséquilibre de phase I/Q devant être corrigée et $f_s$ étant la fréquence d'échantillonnage,
- une unité (304) pour former la moyenne de K coefficients d'étalonnage différents $h_1$ à $h_k$.

**8.** Démodulateur I/Q selon la revendication 7,
**caractérisé en ce que**
des moyens pour régler des valeurs de M à une valeur plus élevée lorsque l'erreur de fréquence de porteuse estimée $\Delta f_{RF}$ diminue.

**9.** Démodulateur I/Q selon l'une quelconque des revendications 7 ou 8, **caractérisé en ce que** des moyens pour régler le nombre de répétitions K à une valeur plus élevée lorsque la valeur du nombre d'échantillons de signaux N diminue.

**10.** Démodulateur I/Q selon l'une quelconque des revendications 7 à 9, dans lequel :

on utilise le système 16-QAM ou 64-QAM.

**11.** Démodulateur I/Q selon l'une quelconque des revendications 7 à 10, comprenant

- une mémoire pour mémoriser la valeur d'écart de fréquence estimée, avec laquelle l'oscillateur local est ajusté lorsque ledit démodulateur I/Q est débranché, et
des moyens pour utiliser la valeur de décalage de fréquence mémorisée dans la mémoire lorsque ledit démodulateur I/Q est branché.

FIG 1

Tx Part

Rx Part

$2 \cdot A_i \cdot \cos(\omega_{L0}t + \varphi_i + \varphi_B)$

$I_{DC,off}$ *)

$-2 \cdot A_q \cdot \sin(\omega_{L0}t + \varphi_q + \varphi_B)$

$Q_{DC,off}$ *)

$2 \cdot \cos(\omega_{L0}t + \varphi_c)$

$-2 \cdot \sin(\omega_{L0}t + \varphi_c)$

*)In the scope of the underlying invention it shall be assumed that $I_{DC,off} = 0$ and $Q_{DC,off} = 0$.

EP 1 416 691 B1

# FIG 2

$2 \cdot A_i \cdot \cos(\omega_{LO}t + \varphi_i + \varphi_B)$

$-2 \cdot A_q \cdot \sin(\omega_{LO}t + \varphi_q + \varphi_B)$

$\xi(t)$

$\eta(t)$

$-A \cdot \sin\theta$

$A \cdot \cos\theta$

$x(t)$

200

202a

202b

204

206a

206b

208

## FIG 3

**Tx Part**

$2 \cdot A_i \cdot \cos[(\omega_{LO} + \Delta\omega_{LO}) \cdot t + \varphi_i + \varphi_B]$

$i(t)$

$-2 \cdot A_q \cdot \sin[(\omega_{LO} + \Delta\omega_{LO}) \cdot t + \varphi_q + \varphi_B]$

$q(t)$

104a  106a

104b  106b  108

**Rx Part**

300

101"

$2 \cdot \cos(\omega_{LO}t + \varphi_c) \Rightarrow 2 \cdot \cos[(\omega_{LO} + \Delta\hat{\omega}_{LO}) \cdot t + \varphi_c]$  310a

$-2 \cdot \sin(\omega_{LO}t + \varphi_c) \Rightarrow -2 \cdot \sin[(\omega_{LO} + \Delta\hat{\omega}_{LO}t) + \varphi_c]$

310b

110a  112a  i'(t)

110b  112b  q'(t)

LPF  LPF

frequency error estimation  306

calculate M  308

calibration coefficient calculation using M samples  302

$\tilde{i}(t)$

$\tilde{q}(t)$

non-coherent accumulation  304

EP 1 416 691 B1